# EUROPÄISCHE PATENTSCHRIFT

(11) **EP 1 129 511 B1**
(45) Veröffentlichungstag und Bekanntmachung des Hinweises auf die Patenterteilung: **19.03.2003**
(21) Anmeldenummer: 99960853.2
(22) Anmeldetag: 02.11.1999
(51) Int. Cl.: H01R 13/646, H01R 12/16, H05K 3/34

(54) **ELEKTRISCHES LEITERPLATTEN-BAUTEIL UND VERFAHREN ZUR AUTOMATISCHEN BESTÜCKUNG VON LEITERPLATTEN MIT SOLCHEN BAUTEILEN**
ELECTRIC COMPONENTS FOR PRINTED BOARDS AND METHOD FOR AUTOMATICALLY INSERTING SAID COMPONENTS IN PRINTED BOARDS
COMPOSANT ELECTRIQUE POUR CARTE DE CIRCUITS ET PROCEDE POUR IMPLANTER AUTOMATIQUEMENT DES COMPOSANTS DE CE TYPE SUR DES CARTES DE CIRCUITS

(30) Priorität: 10.11.1998 DE 19851868
(43) Veröffentlichungstag der Anmeldung: 05.09.2001
(73) Patentinhaber: Tyco Electronics Logistics AG, 9323 Steinach / SG (CH)
(72) Erfinder: LEEMAN, Reginald, B-8400 Oostende (BE); HOUTTEMAN, Bernard, B-8020 Oostkamp (BE); EMBO, Georges, B-8920 Langemark (BE); ACKE, Edgard, B-8020 Oostkamp (BE)
(74) Vertreter: Hirsch, Peter, Dipl.-Ing.
(86) Internationale Anmeldenummer: DE9903493
(87) Internationale Veröffentlichungsnummer: WO00028627

(56) Entgegenhaltungen:
- EP-A- 0 392 549
- GB-A- 2 176 950
- GB-A- 2 303 258
- US-A- 5 141 445
- US-A- 5 394 609

## Beschreibung

Die Erfindung bezieht sich auf ein elektrisches Leiterplatten-Bauteil, insbesondere HF-Koaxial-Steckverbinderteil, bei dem das Gehäuse des Bauteils durch die Lötverbindungen zwischen den an seiner Unterseite vorgesehenen SMD-Lötanschlüssen und diesen leiterplatten-seitig zugeordneten Lötanschlüssen auf der Leiterplatte befestigt ist.

Elektrische Leiterplatten-Bauteile, insbesondere HF-Koaxial-Steckverbinderteile, finden bei elektrischen Übertragungsund Verbindungseinrichtungen eine zahlreiche Verwendung. Grundsätzlich kommen drei verschiedene Anschlußarten für die elektrische Verbindung zwischen den einander zugeordneten bauteileseitigen und leiterplattenseitigen Anschlüssen zur Anwendung.

Bei der Anschlußart - erste Anschlußart -, wie sie beispielsweise bei dem durch die Literaturstelle EP 0 582 960 A1 bekannten Steckverbinderteil zur Anwendung kommt, wird von Preßstiften Gebrauch gemacht, durch die sich ein Lötvorgang erübrigt. Die Verwendung solcher relativ voluminösen Preßstifte setzt jedoch voraus, daß ihre Anzahl mit Rücksicht auf die möglichst kleinen Abmessungen solcher Bauteile pro Bauteil begrenzt ist. Erheblich begrenzt ist ihre Anzahl pro Bauteil aber auch dadurch, daß der aufzuwendende Preßdruck beim Einpressen der bauteileseitigen Preßstifte in die ihnen zugeordneten leiterplattenseitigen kontaktierten Anschlußlöcher einen durch die Festigkeit des Bauteils bedingten Wert nicht überschreiten darf. Der aufzuwendende Preßdruck ist nämlich der Anzahl der vorgesehenen Preßstifte proportional. Für eine automatische Bestückung von Leiterplatten mit solchen Bauteilen sind sehr kostenaufwendige Vorrichtungen erforderlich.

Bei der Anschlußart - zweite Anschlußart -, wie sie beispielsweise bei dem durch die Literaturstelle EP 0 488 482 A1 bekannten Steckverbinderteil zur Anwendung kommt, bestehen die Anschlüsse aus Lötstiften, die aus dünnen Drähten hergestellt sind. Von solchen Lötstiften kann auch in relativ großer Anzahl bei recht klein dimensionierten Bauteilen Gebrauch gemacht werden. Allerdings müssen solche Steckverbinderteile bei der Montage von Hand auf die Leiterplatte aufgesetzt werden, da das Einfädeln der dünnen Lötstifte in die ihnen zugeordneten leiterplattenseitigen Anschlußlöcher schwierig ist. Nach dem Aufsetzen solcher Steckverbinderteile auf die Leiterplatte erfolgt das Verlöten der Lötstifte in den ihnen zugeordneten leiterplattenseitgen Anschlußlöchern durch Schwalllöten.

Bei der Anschlußart - dritte Anschlußart -, wie sie beispielsweise bei dem durch die Literaturstelle DE 197 16 139 C1 bekannten Steckverbinderteil zur Anwendung kommt, werden für die elektrischen Verbindungen zwischen Bauteil und Leiterplatte von Oberflächen-Lötanschlüssen, sogenannte SMD (Surface Mounted Device)-Lötanschlüsse, Gebrauch gemacht. Die Bestückung der Leiterplatten mit SMD-Lötanschlüsse aufweisenden Bauteilen hat im Gegensatz zu solchen mit Preßstiften oder Lötstiften den großen Vorteil, daß sie sich einfach und schnell mit "Pick&Place"-Automaten durchführen läßt. Der Nachteil ist die geringe Festigkeit der durch diese Lötverbindungen herbeigeführten Verankerung des Bauteils auf der Leiterplatte. Aus diesem Grunde muß hier das Bauteil zusätzlich durch Schrauben oder Nieten an der Leiterplatte befestigt werden, um zu verhindern, daß die SMD-Lötverbindungen durch mitunter unvermeidbare stärkere mechanischen Belastungen beschädigt werden oder sogar abreißen.

Der Erfindung liegt die Aufgabe zugrunde, für die ausreichende Befestigung von mit SMD-Lötanschlüssen versehenen elektrischen Bauteilen auf Leiterplatten eine weitere Lösung anzugeben, die ohne Schrauben oder Nieten auskommt und fertigungstechnisch besonders einfach ist.

Diese Aufgabe wird gemäß der Erfindung für eine solches elektrischen Leiterplatten-Bauteil dadurch gelöst, daß das Gehäuse für seine zusätzliche Befestigung auf der Leiterplatte an seiner Unterseite mehrere lötbare Bolzenstifte aufweist, die in ihnen auf der Leiterplatte zugeordnete durchgehende kontaktierte Bolzenlöcher eingreifen und hierin verlötet sind.

Der Erfindung liegt die Erkenntnis zugrunde, daß die Bestükkung von Leiterplatten unter Zuhilfenahme von "Pick&Place"-Automaten auch dann möglich ist, wenn das Bauteil lötstiftartige Verbindungselemente aufweist, die leiterplattenseitig in diesen zugeordneten durchgehenden kontaktierten Löchern verlötet werden. Voraussetzung hierbei ist nur, daß ihr Querschnitt ausreichend groß ist, daß sie von "Pick&Place"-Autoaten beim Aufsetzen des Bauteils auf die Leiterplatte auch als Zentriermittel verwendet werden können.

Zweckmäßige Ausgestaltungen des Gegenstandes nach Patentanspruch 1 sind in den weiteren Patentansprüchen 2 bis 8 angegeben.

In Weiterbildung der Erfindung ist in dem Patentanspruch 9 noch ein besonders zeit- und kostengünstiges Verfahren für die automatische Bestückung von Leiterplatten mit von der Erfindung Gebrauch machenden Leiterplatten-Bauteilen angegeben.

Anhand eines Ausführungsbeispiels, das in der Zeichnung dargestellt ist, soll die Erfindung im folgenden noch näher beschrieben werden. In der Zeichnung bedeuten
- Fig. 1: die perspektivische Darstellung eines Ausführungsbeispiels in Form eines HF-Winkel-Steckverbinderteils,
- Fig. 2: die schematische Darstellung der Verankerung gehäuseseitiger Bolzenstifte in leiterplattenseitigen Bolzenlöchern in einer ersten Ausführungsform,
- Fig. 3: die schematische Darstellung der Verankerung gehäuseseitiger Bolzenstifte in leiterplattenseitigen Bolzenlöchern in einer zweiten Ausführungsform.

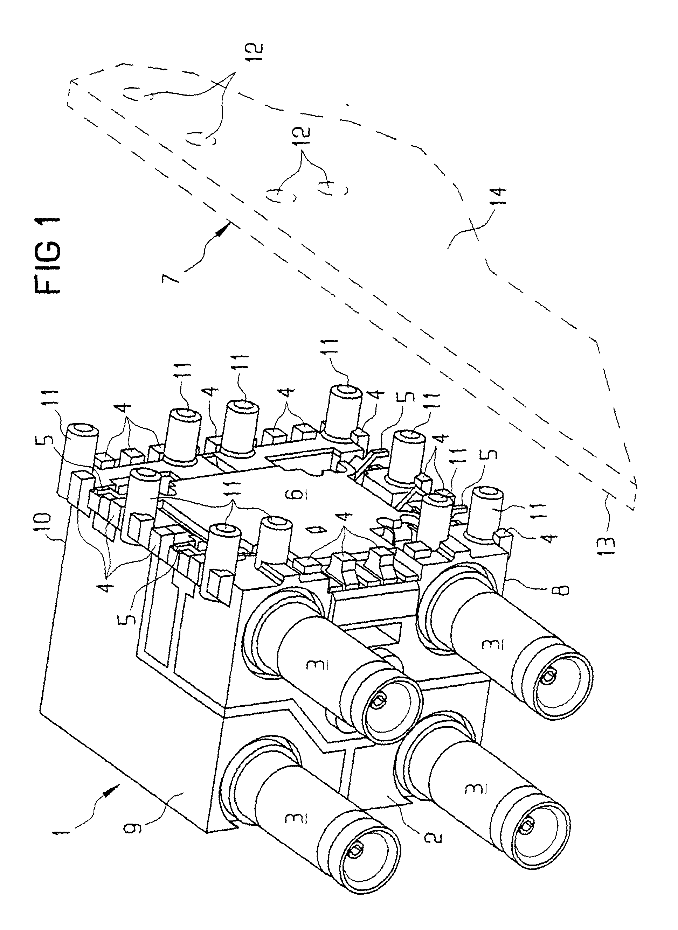

Das in Fig. 1 dargestellte erste Ausführungsbeispiel eines elektrischen Leiterplatten-Bauteils ist ein HF-Winkelsteckverbinderteil. Es entspricht in seiner Grundstruktur dem Steckverbinderteil, das durch die bereits in der Einleitung angegebene Literaturstelle DE 197 16 139 C1 bekannt ist. Aus diesem Grunde dürfte es genügen, wenn hier auf die Struktur der Bauform dieses ersten Ausführungsbeispieles nur insoweit eingegangen wird, als es für das Verständnis der Erfindung erforderlich ist und im übrigen hinsichtlich näherer Details auf die genannte Literaturstelle verwiesen wird.

Das Gehäuse 1, das auch ein Metallgehäuse sein kann, besteht hier aus metallisiertem Kunststoff. Es weist auf der Gegensteckerseite 2 vier Koaxialbuchsen 3 in einer Reihen-Spaltenanordnung auf. Die Schichtstärke der Metallisierung des Gehäuses 1 ist dabei wenigstens gleich der Eindringtiefe der über das Leiterplatten-Bauteil zu übertragenden elektromagnetischen Wellen.

Das Gehäuse 1 hat Kontakt-Standfüße 4 und 5, von denen die Kontakt-Standfüße 4 in einer Vielzahl an der Außenseite des Gehäuses 1 in Nähe seiner Unterseite 6 angeordnet sind. Die Kontakt-Standfüße 4 haben Standflächen, die als verzinnbare SMD-Lötanschlüsse ausgeführt sind. Die Kontakt-Standfüße 5 sind ebenfalls SMD-Lötanschlüsse und bestehen aus den an der Unterseite 6 austretenden, parallel hierzu abgebogenen Enden der metallischen Innenleiter. Die Kontakt-Standfüße 4 und 5 dienen der elektrischen Verbindung ihrer SMD-Lötanschlüsse mit ihnen zugeordneten Lötanschlüssen auf der in Fig. 1 lediglich schematisch in unterbrochenen Linien angegebenen Leiterplatte 7.

Die Kontakt-Standfüße 4 sind an-der Außenseite der Seitenwände 8 und 9 und der Rückwand 10 des Gehäuses 1 in größerer Anzahl vorgesehen und weisen jeweils eine kammartige Struktur auf. Sie haben eine stützstegartige Formgebung und ragen mit ihren SMD-Anschlüssen geringfügig über die Unterseite 6 des Gehäuses 1 hinaus. Entsprechendes gilt für die Kontakt-Standfüße 5 der Innenleiterenden. Weitere Kontakt-Standfüße 4 sind am Rand der Unterseite 6 auf seiten der Gegensteckerseite 2 vorgesehen.

Die Anordnung der Kontakt-Standfüße 4 und 5 an der Außenseite der Seitenwände 8 und 9 und der Rückwand 10 sowie randseitig an der Unterseite 6 auf seiten der Gegensteckerseite 2 ist für das Anlöten ihrer SMD-Lötanschlüsse auf der Leiterplatte 7 von Bedeutung, weil die beim Lötvorgang eingesetzte Umluftwärme so gut an die SMD-Lötanschüsse herangeführt werden kann. Außerdem kann so im Nachhinein leicht überprüft werden, ob die Lötstellen einwandfrei sind. Um beim Verbinden des Gehäuses 1 mit der Leiterplatte 7 für alle SMD-Lötanschlüsse einwandfreie Lötverbindungen sicherzustellen, ist es angebracht, zwischen allen SMD-Anschlüssen der Kontakt-Standfüße 4 und 5 eine Planitätstoleranz < 0,1 mm vorzusehen.

Die Anzahl der insgesamt vorgesehenen Kontakt-Standfüße 4, deren SMD-Lötanschlüsse mit der Metallisierung des Gehäuses 1 elektrisch leitend verbunden sind, wird möglichst groß gewählt, um nach der Herstellung der SMD-Lötverbindungen eine möglichst gute Befestigung des Gehäuses 1 auf der Leiterplatte 7 sicherzustellen. Wie die Praxis zeigt, ist die durch SMD-Lötverbindungen erreichbare Gehäusebefestigung auch bei einer größeren Anzahl von SMD-Lötverbindungen jedoch gering, so daß die für eine solche Befestigung zu fordernde mechanische Belastbarkeit nicht in ausreichendem Maße sichergestellt werden kann.

Für eine'ausreichende mechanische Befestigung des Gehäuses 1 auf der Leiterplatte 7 sind, wie Fig. 1 zeigt zwischen den Kontakt-Standfüßen 4 sowohl an den Außenseiten der Seitenwände 8 und 9 und der Rückwand 10 als auch am Rand der Unterseite 2 auf seiten der Gegensteckerseite 2 mehrere lötfähige Bolzenstifte 11 vorgesehen, die über die Kontakt-Standfüße 4 und 5 hinausragen und beim Aufsetzten auf die Leiterplatte 7 in ihnen zugeordnete kontaktierte Bolzenlöcher 12 in der Leiterplatte 7 eingreifen, in denen sie verlötet werden. Die Bolzenstifte 11 bestehen wie das Gehäuse 1 aus Kunststoff. Sie sind wie die Kontakt-Standfüße 4 stützstegartig an die Gehäusewandungen angeformt und metallisiert.

Das Verlöten der gehäuseseitigen Bolzenstifte 11 in den leiterplattenseitigen kontaktierten Bolzenlöcher 12 kann wie beim Verlöten von Lötstiften durch Schwallöten vorgenommen werden, bei dem die Leiterplatte 7 mit dem auf ihre Oberseite 13 aufgesetzten Gehäuse 1 mit ihrer Unterseite 14 über ein Löt-Schwallbad geführt wird. In diesem Falle müssen also bei der Bestückung der Leiterplatte 7 mit einem Gehäuse 1 zwei Löt-Arbeitsvorgänge durchgeführt werden.

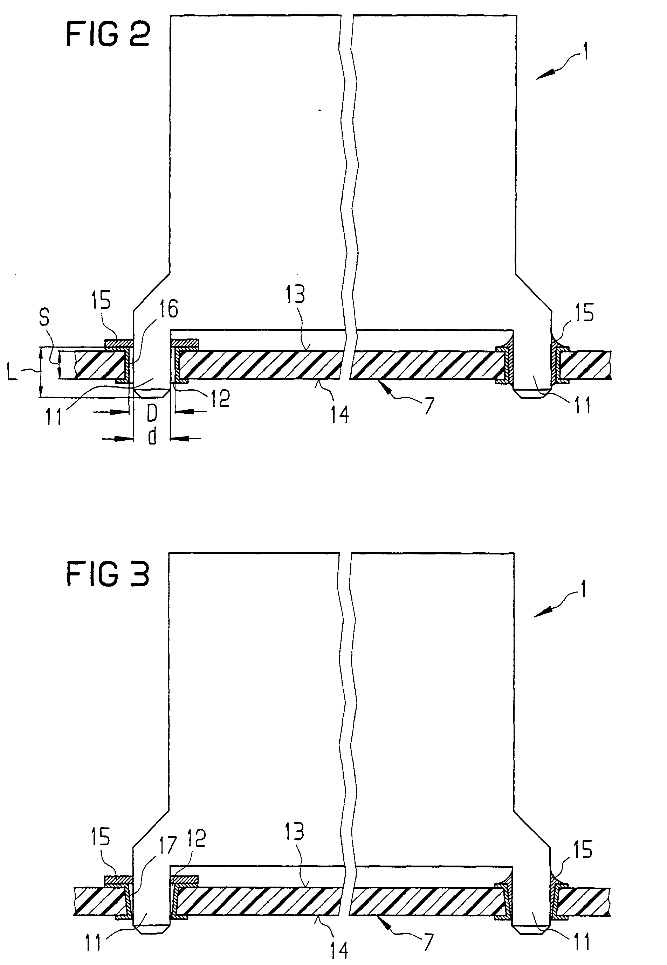

Ein erster Löt-Arbeitsvorgang ist erforderlich für die Herstellung der elektrischen Verbindungen zwischen den gehäuseseitigen SMD-Lötanschlüssen der Kontakt-Standfüße 4 und 5 und den diesen auf der Leiterplatte 7 zugeordneten Lötanschlüssen. Hierbei durchläuft die Leiterplatte 7 mit dem aufgesetzten Gehäuse 1 einen SMD-Lötofen. Sodann muß ein zweiter Löt-Arbeitsvorgang mit einem Löt-Schwallbad für das Verlöten der gehäuseseitigen Bolzenstifte 11 in den ihnen zugeordneten leiterplattenseitigen kontaktierten Bolzenlöchern 12 durchgeführt werden. Das Verlöten der gehäuseseitigen Bolzenstifte 11 in den ihnen zugeordneten leiterplattenseitigen kontaktierten Bolzenlöchern 12 kann aber auch in außerordentlich vorteilhafter Weise ebenfalls nach dem SMD-Lötverfahren durchgeführt werden, so daß bei der Bestückung der Leiterplatte 7 mit einem Gehäuse 1 lediglich ein Löt-Arbeitsvorgang durchgeführt werden muß. Auf diesen Sachverhalt soll im folgenden noch anhand der Fig. 2 und 3 näher eingegangen werden.

Die Fig. 2 und 3 zeigen in schematischer Darstellung den Ablauf des SMD-Lötverfahrens. Jede der Fig. 2 und 3 zeigt ein auf die Leiterplatte 7 aufgesetztes Gehäuse 1. Jedes der Gehäuse 1 ist ausschließlich mit zwei Bolzenstiften 11 dargestellt, von denen der eine an der linken Seitenwand 8 und er andere an der rechten Seitenwand 9 angeformt ist. Beide Bolzenstifte 11 greifen in die ihnen zugeordneten Bolzenlöcher 12 in der Leiterplatte 7 ein. Durch die mittige senkrechte Unterteilung des Gehäuses 1 und der Leiterplatte 7 in eine linke und eine rechte Hälfte soll der SMD-Lötvorgang angedeutet werden. Hierbei ist jeweils das leiterplattenseitige kontaktierte Bolzenloch 12 mit dem hierin eingreifenden gehäuseseitigen Bolzenstift 11 bei der linken Hälfte im Zustand vor und bei der rechten Hälfte im Zustand nach dem Durchgang der Leiterplatte 7 mit dem aufgesetzten Gehäuse 1 durch den SMD-Lötofen dargestellt.

Bevor das Gehäuse 1 auf die Leiterplatte 7 aufgesetzt wird, müssen alle Lötanschlüsse auf der Oberseite 13 der Leiterplatte 7 mit einer Lötpastenauflage versehen werden. Hierzu wird eine Lötpastenmaske verwendet. Im Bereich der Bolzenlöcher 12 wird die Lötpaste 15 über diese hinweg aufgetragen. Nach dem Durchlauf durch den SMD-Lötofen ist die Lötpaste, wie die jeweils rechte Hälfte der Fig. 2 und 3 gut erkennen läßt, in den Hohlraum zwischen dem Bolzenstift 11 und der kontaktierten Wandung des Bolzenlochs 12 eingeflossen, wodurch der Bolzenstift 11 im Bolzenloch fest verlötet wird.

Der Unterschied zwischen den Fig. 2 und 3 besteht lediglich in der Form der Bolzenlöcher 12. Während die kontaktierte Innenwandung 16 der Bolzenlöcher 12 in Fig. 2 senkrecht ausgeführt ist, ist die kontaktierte Innenwandung 17 der Bolzenlöcher 12 in Fig. 3 leicht konusförmig gestaltet. Diese Ausführungsform kann mitunter sinnvoll sein, um zu verhindern, daß beim Durchgang der Leiterplatte 7 durch den SMD-Lötofen die verflüssigte Lötpaste 15 teilweise nach unten von der Unterseite 14 der Leiterplatte 7 abtropft. Im allgemeinen läßt sich dies jedoch bei senkrecht gestalteter Innenwandung 16 durch eine geeignete, aufeinander abgestimmte Bemessung von Bolzenstift- und Bolzenloch-Durchmesser selbst dann unterbinden, wenn sich die Bolzenstifte 11 zu ihrem freien Ende hin leicht konisch verjüngen. Beim in der Zeichnung dargestellten Ausführungsbeispiel wurden bei einer Dicke S der Leiterplatte 7 von 1,6 mm folgende Abmessungen vorgesehen:
Bolzenlochdurchmesser D = 2,3 mm
Bolzenstiftdurchmesser d = 1,8 mm
Bolzenstiftlänge L = 2,2 mm

## Patentansprüche

1. Elektrisches Leiterplatten-Bauteil, insbesondere HF-Koaxial-Steckverbinderteil, bei dem das Gehäuse (1) des Bauteils durch die Lötverbindungen zwischen den an seiner Unterseite (6) vorgesehenen SMD-Lötanschlüssen und diesen leiterplattenseitig zugeordneten Lötanschlüssen auf der Leiterplatte (7) befestigt ist,
**dadurch gekennzeichnet, daß**
das Gehäuse (1) für seine zusätzliche Befestigung auf der Leiterplatte (7) an seiner Unterseite (6) mehrere lötbare Bolzenstifte (11) aufweist, die in ihnen auf der Leiterplatte (7) zugeordnete durchgehende kontaktierte Bolzenlöcher (12) eingreifen und hierin verlötet sind.

2. Elektrisches Leiterplattenbauteil nach Anspruch 1,
**dadurch gekennzeichnet, daß**
die Lötverbindungen zwischen den gehäuseseitigen Bolzenstiften (11) in den leiterplattenseitigen Bolzenlöchern (12) wie SMD-Lötverbindungen ausgeführt sind.

3. Elektrisches Leiterplattenbauteil nach Anspruch 1 oder 2,
**dadurch gekennzeichnet, daß**
das Gehäuse (1) einschließlich seiner Bolzenstifte (11) aus Kunststoff besteht und
wenigstens die Bolzenstifte (11) mit einer lötfähigen Metallisierung versehen sind.

4. Elektrisches Leiterplattenbauteil nach Anspruch 3,
**dadurch gekennzeichnet, daß**
die metallisierten Bolzenstifte (11) auf Bezugspotential liegen.

5. Elektrisches Leiterplattenbauteil nach einem der vorhergehenden Ansprüche,
**dadurch gekennzeichnet, daß**
der Querschnitt der Bolzenstifte (11) größer gewählt ist als der Querschnitt der bei solchen Bauteilen üblicherweise verwendeten, aus dünnen Drähten hergestellten Lötstifte.

6. Elektrisches Leiterplattenbauteil nach Anspruch 5,
**dadurch gekennzeichnet, daß**
der Querschnitt der Bolzenstifte (11) unter Berücksichtigung ihrer Anzahl und ihrer Materialbeschaffenheit so groß gewählt ist, daß die mechanische Belastbarkeit der Befestigung des Gehäuses (1) auf der Leiterplatte (7) die hieran gestellten Anforderungen in ausreichendem Maße erfüllt.

7. Elektrisches Leiterplattenbauteil nach einem der vorhergehenden Ansprüche,
**dadurch gekennzeichnet, daß**
die über die Unterseite (6) des Gehäuses (1) überstehenden Bolzenstifte (11) Ansätze darstellen, die vorzugsweise am unteren Rand des Gehäuses (1) an den Außenseiten seiner Seitenwände (8, 9) und seiner Rückwand (10) angeformt sind.

8. Elektrisches Leiterplattenbauteil nach einem der vorhergehenden Ansprüche,
**dadurch gekennzeichnet, daß**
die kontaktierte Innenwandung (17) der leiterplattenseitigen Bolzenlöcher (12) leicht konusförmig gestaltet ist und
die so gestalteten Bolzenlöcher (12) hierbei ihre größere lichte Weite auf der Seite der Leiterplatte (7) aufweisen, auf der die gehäuseseitigen Bolzenstifte (11) in die Bolzenlöcher (12) eingreifen.

9. Verfahren zur automatischen Bestückung von Leiterplatten mit elektrischen Leiterplatten-Bauteilen nach Anspruch 1,
**dadurch gekennzeichnet, daß**
in einem ersten Schritt unter Zuhilfenahme einer Lötpastenmaske alle Lötanschlüsse und alle Bolzenlöcher (12) auf der Leiterplatte (7) mit einer Auflage aus Lötpaste (15) versehen werden,
in einem zweiten Schritt das Gehäuse (1) von einem "Pick&Place"-Automaten aufgenommen und unter Ausnutzung der durch die gehäuseseitigen Bolzenstifte (11) und die leiterplattenseitigen Bolzenlöcher (12) gegebenen Zentriermöglichkeit auf die Leiterplatte (7) aufgesetzt wird und
in einem dritten Schritt die Leiterplatte (7) mit dem hierauf aufgesetzten Gehäuse (1) einen SMD-Lötofen durchläuft, in dem in einem Arbeitsgang die gehäuseseitigen SMD-Lötanschlüsse der Kontakt-Standfüße (4, 5) mit den ihnen leiterplattenseitig zugeordneten Lötanschlüssen einerseits und die gehäuseseitigen Bolzenstifte (11) in den ihnen leiterplattenseitig zugeordneten Bolzenlöchern (12) andererseits fest verlötet werden.

## Claims

1. An electrical printed circuit board component, in particular an HF coaxial plug connector part, in which the housing (1) of the component is secured to the printed circuit board (7) by the soldered connections between the SMD soldered terminals provided on its underside (6) and soldered terminals associated with these on the printed circuit board side, **characterised in that**
for the purpose of additionally securing it to the printed circuit board (7), the housing (1) has on its underside (6) a plurality of solderable stud-like pins (11) which engage in contact-making stud holes (12) associated therewith in the printed circuit board (7), passing all the way through, and which are soldered therein.

2. An electrical printed circuit board component according to Claim 1, **characterised in that** the soldered connections between the stud-like pins (11) on the housing side in the stud holes (12) on the printed circuit board side are made in the form of SMD soldered connections.

3. An electrical printed circuit board component according to Claim 1 or 2, **characterised in that**
the housing (1), including its stud-like pins (11), is made from synthetic material, and
at least the stud-like pins (11) are provided with a solderable metallisation.

4. An electrical printed circuit board component according to Claim 3, **characterised in that** the metallised stud-like pins (11) are at reference potential.

5. An electrical printed circuit board component according to one of the preceding claims, **characterised in that** the cross-section of the stud-like pins (11) is selected to be larger than the cross-section of the solder pins which are conventionally used in components of this type and which are made from thin wires.

6. An electrical printed circuit board component according to Claim 5, **characterised in that** the cross-section of the stud-like pins (11) is selected, taking into account their number and the nature of their material, to be large enough for the mechanical loading capacity of the securing of the housing (1) to the printed circuit board (7) to adequately fulfil the requirements made thereof.

7. An electrical printed circuit board component according to one of the preceding claims, **characterised in that** the stud-like pins (11) projecting beyond the underside (6) of the housing (1) form extension pieces which are preferably integrally formed on the lower edge of the housing (1) on the outsides of its side walls (8, 9) and its rear wall (10).

8. An electrical printed circuit board component according to one of the preceding claims, **characterised in that**
the contact-making inner wall (17) of the stud holes (12) in the printed circuit board side is shaped to be slightly conical, and
the stud holes (12) shaped in this way in this case have their larger internal diameter on that side of the printed circuit board (7) on which the stud-like pins (11) on the housing side engage in the stud holes (12).

9. A process for automatically fitting electrical printed circuit board components according to Claim 1 onto printed circuit boards, **characterised in that**
in a first step, with the aid of a solder paste mask, all the soldering terminals and all the stud holes (12) on the printed circuit board (7) are provided with a layer of solder paste (15),
in a second step the housing (1) is picked up by a pick & place machine and, exploiting the possibility for centring which is provided by the stud-like pins (11) on the housing side and the stud holes (12) on the printed circuit board side, is placed on the printed circuit board (7) and
in a third step the printed circuit board (7) runs, together with the housing (1) placed thereon, through an SMD soldering furnace in which, in one operational procedure, the SMD soldering terminals of the contact feet (4, 5) on the housing side are firmly soldered to the soldering terminals associated therewith on the printed circuit board side on the one hand, and on the other hand the stud-like pins (11) on the housing side are firmly soldered in the stud holes (12) associated therewith on the printed circuit board side.

## Revendications

1. Composant électrique pour carte de circuits, en particulier un composant de connecteur coaxial HF, le boîtier (1) du composant étant fixé sur la carte de circuits (7) par les raccordements de soudage entre les connexions soudées SMD sur son côté inférieur (6) et les connexions soudées correspondantes sur la carte de circuits, **caractérisé en ce que**
le boîtier (1) comporte en vue de sa fixation supplémentaire sur la carte de circuits (7) plusieurs broches à boulon à soudage (11) au niveau de son côté inférieur (6), s'engageant dans des trous à boulon de passage de contact correspondants (12) sur la carte de circuits (7) et fixées par soudage dans ceux-ci.

2. Composant électrique pour carte de circuits selon la revendication 1, **caractérisé en ce que** les raccordements de soudage entre les broches à boulon (11) du boîtier ont la forme de connexions soudées SMD dans les trous à boulon sur la carte de circuits (12).

3. Composant électrique pour carte de circuits selon les revendications 1 ou 2, **caractérisé en ce que**
le boîtier (1) et les broches à boulon correspondantes (11) sont composés de plastique, et
au moins les broches à boulon (11) comportant une métallisation se prêtant au soudage.

4. Composant électrique pour carte de circuits selon la revendication 3, **caractérisé en ce que** les broches à boulon métallisées (11) sont mises au potentiel de référence.

5. Composant électrique pour carte de circuits selon l'une des revendications précédentes, **caractérisé en ce que** la section transversale des broches à boulon (11) est plus grande que la section transversale des broches de soudage composés de fils fins, normalement utilisés sur de tels composants.

6. Composant électrique pour carte de circuits selon la revendication 5, **caractérisé en ce que** la section transversale des broches à boulon (11) est dimensionnée, compte tenu de leur nombre et de la nature de leur matériau, de sorte que la capacité de charge mécanique de la fixation du boîtier (1) sur la carte de circuits (7) est assez grande pour répondre de manière satisfaisante aux exigences correspondantes.

7. Composant électrique pour carte de circuits selon l'une des revendications précédentes, **caractérisé en ce que** les broches à boulon (11) débordant au-delà du côté inférieur (6) du boîtier (1) constituent des épaulements, agencés de préférence sur le bord inférieur du boîtier (1), au niveau des côtés externes de ses parois latérales (8, 9) et de sa paroi arrière (10).

8. Composant électrique pour carte de circuits selon l'une des revendications précédentes, **caractérisé en ce que**
la paroi interne de contact (17) des trous à boulon (12) de la carte de circuits est légèrement cunéiforme, et
les trous à boulon ainsi configurés (12) ayant ainsi leur largeur libre maximale sur le côté de la carte de circuits (7), sur lequel les broches à boulon (11) du boîtier s'engagent dans les trous à boulon (12).

9. Procédé d'équipement automatique de cartes de circuits avec des composants électriques pour cartes de circuits selon la revendication 1, **caractérisé en ce que**
au cours d'une première étape, toutes les connexions soudées et tous les trous à boulon (12) sur la carte de circuits (7) sont pourvus d'un revêtement de pâte à souder (15) par l'intermédiaire d'un masque de pâte à souder ;
au cours d'une deuxième étape, le boîtier (1) est reçu par un dispositif automatique « Pick & Place » et appliqué sur la carte de circuits (7) en exploitant la possibilité de centrage établie par les broches à boulon (11) du boîtier et les trous à boulon (12) sur la carte de circuits ; et
au cours d'une troisième étape, la carte de circuits (7), avec le boîtier (1) qui y est appliqué, traverse un four à braser SMD, dans lequel une seule opération permet la fixation ferme par soudage des connexions soudées SMD sur les pieds de support de contact (4, 5) du boîtier aux connexions soudées correspondantes de la carte de circuits et des broches à boulon (11) du boîtier dans les trous à boulon (12) correspondants sur la carte de circuits.
